# EUROPÄISCHE PATENTSCHRIFT

(11) **EP 0 281 061 B1**
(45) Veröffentlichungstag und Bekanntmachung des Hinweises auf die Patenterteilung: **11.01.1995**
(21) Anmeldenummer: 88103034.0
(22) Anmeldetag: 01.03.1988
(51) Int. Cl.: H03M 7/30

(54) **Schaltungsanordnung zur Kompression von Datenworten mit Hilfe eines Skalenfaktors**
Circuitry for the compression of digital data words by means of a scale factor
Circuit pour la compression de mots de données numériques au moyen d'un facteur d'échelle

(30) Priorität: 03.03.1987 DE 3706791
(43) Veröffentlichungstag der Anmeldung: 07.09.1988
(73) Patentinhaber: Deutsche Thomson-Brandt GmbH, 78003 Villingen-Schwenningen (DE)
(72) Erfinder: Lüdecke, Joachim, Dipl.-Ing., D-3160 Lehrte 4 (DE)

(56) Entgegenhaltungen:
- EP-A- 0 133 697
- FR-A- 2 112 726
- GB-A- 2 125 255

## Beschreibung

Die Erfindung betrifft eine Anordnung zur Kompression von Datenworten mit Hilfe einer Skalenfaktor-Berechnungsschaltung.

Bei der Datenfernübertragung oder Speicherung besteht häufig das Problem, mehrere Datenkanäle in einem vorgegebenen Rahmen unterzubringen. Ist der Rahmen dabei geringer als der Umfang der Datenworte der Datenkanäle, so läßt sich das Problem nur durch eine Kompression der Datenworte bewältigen.
In EP-A-0 133 697 ist die Erzeugung eines komprimierten Codes beschrieben, der nur die höchstwertigen Bits in Verbindung mit einem den Größenwert des zu codierenden Datenwortes angegebenen Skalenfaktor enthält. Dazu wird ein Schieberegister verwendet, dessen Taktimpulse in Abhängigkeit vom Skalenfaktor zeitweise unterdrückt werden.

Der Erfindung liegt die Aufgabe zugrunde, eine Anordnung zur Kompression von Datenworten mit Hilfe eines Skalenfaktors zu schaffen, welche bei geringem schaltungstechnischen Aufwand - insbesondere bei geringem erforderlichen Speicherplatz - eine sehr schnelle Datenverarbeitung ermöglicht.

Diese Aufgabe wird bei einer Anordnung nach dem Oberbegriff des Anspruchs 1 durch die im kennzeichnenden Teil angegebenen Merkmale gelöst.

Durch die Aufspaltung der Datenworte der unkomprimierten Daten lassen sich auch die Teile der Adressenworte aufspalten, die für die Zuordnung der unkomprimierten Daten an Hand einer Codetabelle erforderlich sind. Dabei geht die Erfindung von der Erkenntnis aus, daß für Teile der Datenworte der unkomprimierten Daten ein eingeschränkter Adressenbereich ausreichend ist, so daß auch die umkomprimierten Datenworte verkürzt werden können und daraus Adressenworte gebildet werden können. Die Bemessung ist dabei so gewählt, daß die Wortlänge der Adressenworte nur um die Wortlänge der Teile von Datenworten verkürzt werden, die den unkomprimierten Daten entsprechen. Auf diese Weise wird ein Überlappungsbereich erhalten, der die erforderlichen Informationen für eine richtige Zuordnung der Datenworte für die komprimierten Daten sicherstellt. Die Erfindung ermöglicht es, den Speicherbereich gegenüber einer Matrix, welche eine vollständige Codetabelle der Zuweisungen der komprimierten Datenwort zu den unkomprimierten Datenworte enthält, um den Kompressionsfaktor zu reduzieren. Dies bedeutet besonders bei umfangreichen Codetabellen erhebliche Vorteile bei der schaltungstechnischen Realisierung der Speicher sowie der Zuverlässigkeit und dem Raumbedarf. Dabei ermöglicht die Lösung eine hohe Datenverarbeitungsgeschwindigkeit, wie sie bei einer parallelen Verarbeitung der Datenworte, also einer gleichzeitigen Umsetzung aller Bit eines Datenwortes üblich ist.

Eine bevorzugte Ausführungsform der Anordnung dient der Kompression zur Datenreduktion auf der Basis von NICAM-codierungen wie z.B. bei D2-Mac. Bei diesem Übertragungsverfahren ist es wünschenswert, mehrere Stereotonkanäle gleichzeitig zu übertragen. Dies ist in der linearen Betriebsart nicht möglich, sondern erfordert die Umschaltung in die komprimierte Betriebsart. Diese unterscheidet sich von der linearen Betriebsart dadurch, daß Datenworte statt einer Wortlänge von 14 Bit nur mit einer Wortlänge von 10 Bit übertragen werden. Die Kompression erfolgt über einen Skalenfaktor der jedoch keine lineare Abhängigkeit zwischen den Codeworten bietet. Da bei beiden Datenworten also denjenigen für die unkomprimierten und die komprimierten Daten das Bit der höchsten Wertigkeit für die Polarität reserviert ist, verbleiben für die Durchführung der Kompression nur die restlichen 13 Bit des unkomprimierten Datenwortes die in 9 Bit des komprimierten Datenwortes umgesetzt werden müssen. Bei der gleichmäßigen Aufspaltung des Datenwortes für die komprimierten Daten bietet es sich somit an, entsprechend der Lehre der Erfindung eine Aufteilung in drei Teile vorzunehmen und so komprimierte Datenworte von je 3 Bit zu erhalten. Das als Adressenwort dienende Datenwort läßt sich dann um die Differenz aus der Wortlänge des unkomprimierten Datenwortes, also 13 Bit und der Wortlänge der übrigen Teile der für die komprimierten Daten vorgesehenen Datenworte, also 6 Bit vermindern, so daß sich eine Wortlänge der Adressenworte von je 7 Bit ergibt. Zusätzlich kommt noch der Skalenfaktor hinzu, welcher bei D2-Mac 3 Bit beträgt. Insgesamt wird somit eine Wortlänge von 7 Adressenworten und 3 Skalenfaktorworten benötigt. Die Speicherplatzreduktion ist damit fast die gleiche wie der Kompressionsfaktor.

Weiterbildungen des Verfahrens und der Schaltungsanordnung ergeben sich aus den weiteren Ansprüchen, der Beschreibung und der Zeichnung, die ein Ausführungsbeispiel des Gegenstandes der Erfindung veranschaulicht.

In der Zeichnung zeigen:
- Fig. 1: eine Zuordnungstabelle zur Veranschaulichung der Kompression von 14 Bit Datenwörtern in 10 Bit Datenwörtern,
- Fig. 2: eine Schaltungsanordnung zur Durchführung der Kompression und
- Fig. 3: eine Codetabelle.

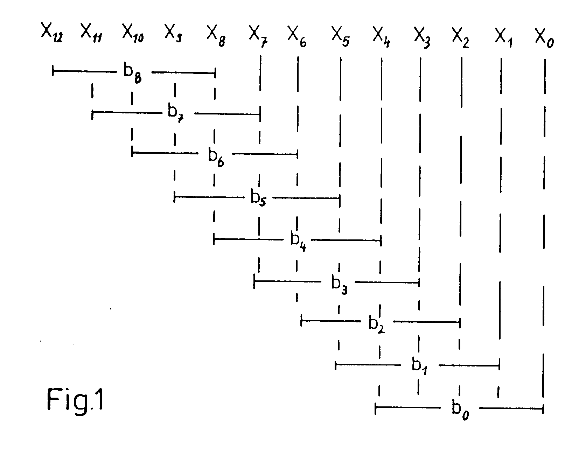

In Fig. 1 sind die einzelnen Stellen des für die unkomprimierten Daten vorgesehenen Datenwortes sowie die Stellen des für die komprimierten Daten vorgesehenen Datenwortes aufgetragen, welche durch den Skalenfaktor einander zugeordnet werden. Da beim unkomprimierten und komprimierten Datenwort dem Bit der höchsten Wertigkeit die Polarität zugewiesen ist und dieses unverändert erhalten bleibt, somit nicht der Datenverarbeitung unterliegt, ist dies bei der Darstellung der Zuordnung der beiden Datenworte nicht mitgezeichnet worden. Wie die Zeichnung erkennen läßt, weisen die Stellen b einen Variationsbereich von 5 Stellen auf, innerhalb dessen sie bestimmten Stellen des unkomprimierten Datenwortes X zugewiesen werden können.

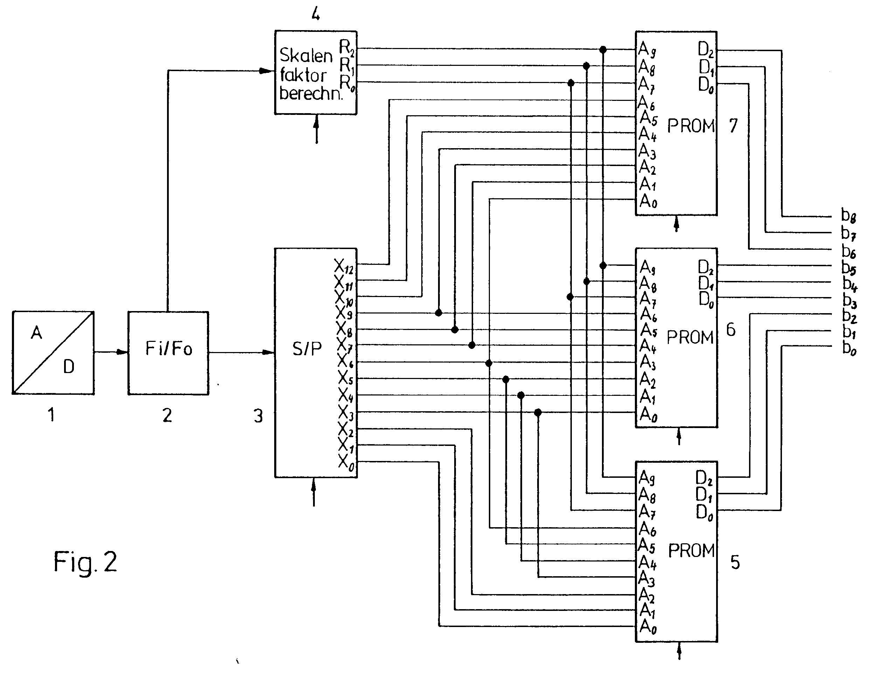

In Fig. 2 ist eine Schaltungsanordnung zur Kompression von Datenworten mit Hilfe eines Skalenfaktors dargestellt. Die Schaltung umfaßt im einzelnen einen Analog/Digital-Wandler 1, ein mit FiFo bezeichnetes Schieberegister 2, einen mit S/P bezeichneten Serien/Parallel-Wandler 3, eine Schaltung zur Berechnung eines Skalenfaktors 4 und drei programmierbare Lesespeicher 5, 6 und 7. Die Stellen für die unkomprimierten Daten der Datenworte am Ausgang des Serien/Parallel-Wandlers 3 sind mit X bezeichnet und tragen einen Index, der die Wertigkeit der Stelle angibt. Die Ausgänge der Schaltung zur Berechnung des Skalenfaktors 4 sind mit R bezeichnet und besitzen ebenfalls Indices zur Angabe der Wertigkeit der Stellen. Die gleiche Systematik ist auch bei der Bezeichnung der Adresseneingänge A der programmierbaren Lesespeicher 5, 6 und 7 sowie deren Datenausgänge D getroffen. Die Leitungen, auf denen die komprimierten Datenworte auftreten, sind mit b bezeichnet, wobei ebenfalls Indices die Wertigkeit der Stellen angeben.

Von den zur Verfügung stehenden Adresseneingängen A0 - A9 der programmierbaren Lesespeicher 5, 6 und 7 sind nur die ersten sieben Stellen, nämlich A0 - A6 mit den Ausgängen des zweiten Schieberegisters 3 verbunden. Die Zuordnung ist dabei so erfolgt, daß die Ausgänge X0 - X6 des zweiten Schieberegisters 3 mit den Adresseneingängen A0 - A6 des programmierbaren Lesespeichers 5, die Ausgänge X3 - X9 mit den Adresseneingängen A0 - A6 des programmierbaren Lesespeichers 6 und die Ausgänge X6 - X12 mit den Adresseneingängen A0 - A6 des programmierbaren Lesespeichers 7 verbunden sind. Es besteht also eine gewisse Überlappung zwischen den Datenworten, die den Adresseneingängen A0 - A6 der programmierbaren Lesespeicher 5, 6 und 7 zugeführt werden. Die restlichen Adresseneingänge A7 - A9 aller programmierbaren Lesespeicher 5, 6 und 7 sind parallel geschaltet und gemeinsam mit den Ausgängen R0, R1, R2 der Schaltungsanordnung zur Berechnung des Skalenfaktors 4 verbunden. Die Ausgänge D0-D2 der programmierbaren Lesespeicher 5, 6, 7 ergeben ein neunstelliges komprimiertes Datenwort, wobei die Ausgänge D0 - D2 des programmierbaren Lesespeichers 5 die Stellen b0 - b2, die Ausgänge D0 - D2 des programmierbaren Lesespeichers 6 die Stellen b3 - b5 und die Ausgänge D0 bis D2 des programmierbaren Lesespeichers 7 die Stellen b6 - b8 ergeben.

Im Betrieb der Schaltungsanordnung werden durch den Analog/Digital-Wandler 1 analoge Signale, z.B. Stereotonsignale, in digitale Signale umgewandelt und zwar bei D2-Mac in Signale mit Datenworten von 14 Bit Wortlänge. In dem Schieberegister 2 werden zunächst 32 Datenworte abgewartet und daraufhin in der Schaltung zur Berechnung des Skalenfaktors wieder berechnet.

Auf Grund des ermittelten Skalenfaktors werden nun den Stellen des komprimierten Datenwortes entsprechende Stellen des unkomprimierten Datenwortes zugeordnet. Es wird also beispielsweise entschieden, ob die Stelle b0 des komprimierten Datenwortes dem Ausgang X0, X1, X2, X3 oder X4 zugeordnet wird. Entsprechendes gilt auch für die anderen Stellen b1- b8. Da eine gleichmäßige Verschiebung aller Stellen erfolgt, ist es möglich, die programmierbaren Lesespeicher 5, 6, 7 mit gleichen Speicherinhalten auszustatten. Der Speicherinhalt entspricht dabei einer Codetabelle, wie er nach der D2-Mac Spezifikation zwischen der sogenannten linearen Betriebsart, "linear code", und der komprimierten Betriebsart, "companded code" besteht.

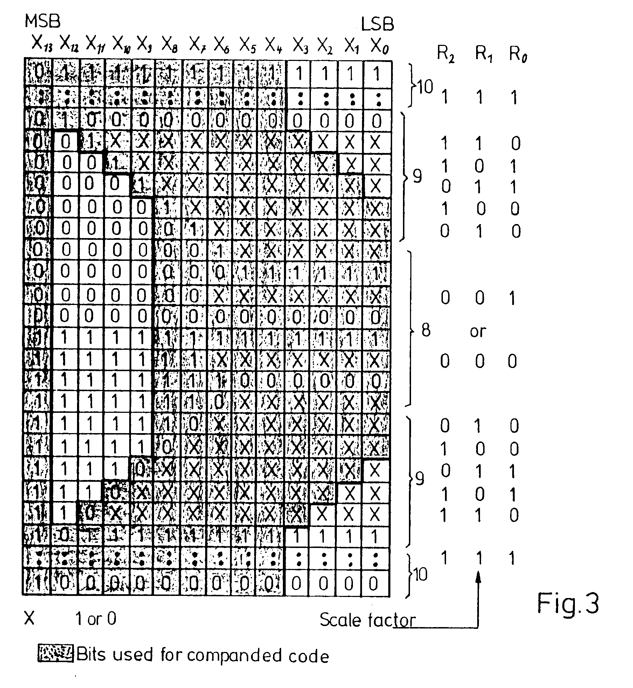

Dieser Zusammenhang ist in Fig. 3 dargestellt, wobei das quadratische Feld die lineare Betriebsart, und der grau hinterlegte Teil des quadratischen Feldes die komprimierte Betriebsart zeigt. Der Skalenfaktor für bestimmte Datenworte ist rechts neben der Codetabelle angegeben. Es zeigt sich, daß der Skalenfaktor in einem mittleren Bereich 8 geringer Dynamik konstant ist, in Übergangsbereichen 9 für verschiedene Dynamikstufen variabel und in Bereichen höchster Dynamik wieder konstant ist. Der Zusammenhang zwischen den komprimierten- und unkomprimierten Datenworten läßt sich also nicht durch lineare Verschiebung der Wertigkeit der Stellen in Abhängigkeit der Dynamik darstellen. Daher bietet die Tabelle die schnellstmögliche Zuordnung zwischen den komprimierten und unkomprimierten Datenworten. Eine direkte Lösung mit einem Lesespeicher würde einen Speicherplatz erfordern, der sich unter Berücksichtigung der unkomprimierten Datenworte von 13 Bit zuzüglich des Skalenfaktors von 3 Bit und den Datenworten der komprimierten Datenworte von 9 Bit zu 2¹⁶x 9 Bit = 589824 Bit ergibt. Dagegeben benötigt die erfindungsgemäße Lösung nur eine Kapazität von 2¹⁰ x 3 x 3 Bit = 9216 Bit. Dies entspricht einer Reduzierung der sonst notwendigen Speicherkapazität um den Faktor 64.

## Patentansprüche

1. Anordnung zur Kompression von Datenworten mit Hilfe einer Skalenfaktor-Berechnungsschaltung (4) und zugeordneter Schieberegister-Mittel (2), **dadurch gekennzeichnet**, daß die Datenbits (X₀...X₁₂) der unkomprimierten Datenworte an Adresseingänge (A₀...A₆) von Festwertspeichern (5, 6, 7) gelegt werden, in denen Codetabellen für jeweils einen Datenwort-Teil (b₀, b₁, b₂; b₃, b₄, b₅; b₆, b₇, b₈) der komprimierten Datenworte gespeichert sind, wobei die Ansteuerung eines Teils der Adresseingänge (A₀...A₆) durch überlappende Gruppen (X₀...X₆, X₃...X₉, X₆...X₁₂) von unkomprimierten Datenbits und die Ansteuerung eines weiteren Teils der Adresseingänge (A₇, A₈, .A₉) durch die Bits (R₀, R₁, R₂) eines gemeinsamen, in der Skalenfaktor-Berechnungsschaltung (4) generierten Skalenfaktors geschieht und wobei die Anzahl der überlappenden Datenbits der Differenz zwischen der Länge des unkomprimierten und des komprimierten Datenworts entspricht.

2. Anordnung nach Anspruch 1, **dadurch gekennzeichnet**, daß die Kompression zur Datenreduktion auf der Basis von NICAM-Codierungen, wie z.B. bei D2-MAC, dient und daß drei Festwertspeicher-Bereiche oder gesonderte Festwertspeicher (5, 6, 7) mit jeweils zehn Adresseingängen (A₀...A₉) und jeweils drei Datenausgängen (D₀...D₂) vorgesehen sind, daß der eine Teil der Adresseingänge für die unkomprimierten Datenbits jeweils sieben dieser Adresseingänge (A₀...A₆) und der weitere Teil für die Bits des Skalenfaktors jeweils die restlichen drei Adresseingänge (A7...A9) umfaßt.

3. Anordnung nach Anspruch 2, **dadurch gekennzeichnet**, daß die sieben Adresseingänge (A₀...A₆) für die Wertigkeiten 2⁰...2⁶ des ersten Festwertspeicher-Bereichs oder Festwertspeichers (5) mit Bits der Wertigkeiten 2⁰...2⁶ der unkomprimierten Datenworte, die gleichen Adresseingänge (A₀...A₆) des zweiten Festwertspeicher-Bereichs oder Festwertspeichers (6) mit Bits der Wertigkeiten 2³...2⁹ der unkomprimierten Datenworte und die gleichen Adresseingänge (A₀...A₆) des dritten Festwertspeicher-Bereichs oder Festwertspeichers (7) mit Bits der Wertigkeiten 2⁶...2¹² der unkomprimierten Datenworte angesteuert werden.

4. Anordnung nach einem oder mehreren der Ansprüche 1 bis 3, **da****durch gekennzeichnet**, daß das höchstwertige Bit der unkomprimierten Datenworte insbesondere die Polarität der Datenworte darstellt und bei der Kompression unverändert erhalten bleibt.

## Claims

1. Arrangement for compressing data words with the help of a scaling-factor calculating circuit (4) and associated shift register means (2), characterised in that, the data bits (X₀ ... X₁₂) of the uncompressed data words are applied to address inputs (A₀ ... A₆) of permanent stores (5, 6, 7) in which code tables for a respective data word part (b₀, b₁, b₂; b₃, b₄, b₅; b₆, b₇, b₈) of the compressed data words are stored, wherein the control of a portion of the address inputs (A₀ ... A₆) is effected by overlapping groups (X₀ ... X₆, X₃ ... X₉, X₆ ... X₁₂) of uncompressed data bits and the control of a further portion of the address inputs (A₇, A₈, A₉) is effected by the bits (R₀, R₁, R₂) of a common scaling factor which is generated in the scaling-factor calculating circuit (4) and wherein the number of overlapping data bits corresponds to the difference between the length of the uncompressed and of the compressed data word.

2. Arrangement in accordance with Claim 1, characterised in that, the compression serves for data reduction on the basis of NICAM codings such as for D2-MAC for example, and that three permanent storage regions or special permanent stores (5, 6, 7) each having ten address inputs (A₀ ... A₉) and three data outputs (D₀ ... D₂) are provided, that the one portion of the address inputs for the uncompressed data bits comprises seven of these respective address inputs (A₀ ... A₆) and the further portion for the bits of the scaling factor comprises the respective three remaining address inputs (A7 ... A9).

3. Arrangement in accordance with Claim 2, characterised in that, the seven address inputs (A₀ ... A₆) for the significant places 2⁰ ... 2⁶ of the first permanent storage region or permanent store (5) are controlled by bits of the significant places 2⁰ ... 2⁶ of the uncompressed data words, the same address inputs (A₀ ... A₆) of the second permanent storage region or permanent store (6) are controlled by bits of the significant places 2³ ... 2⁹ of the uncompressed data words and the same address inputs (A₀ ... A₆) of the third permanent storage region or permanent store (7) are controlled by bits of the significant places 2⁶ ... 2¹² of the uncompressed data words.

4. Arrangement in accordance with one or more of the Claims 1 to 3, characterised in that, the most significant bit of the uncompressed data words represents, in particular, the polarity of the data words and remains unaltered during the compression.

## Revendications

1. Dispositif pour la compression de mots de données à l'aide d'un circuit de calcul du facteur de cadrage (4) et un organe à registre à décalage correspondant (2), **caractérisé en ce** que les bits de données (X₀...X₁₂) des mots de données non comprimées sont appliqués à des entrées d'adresse (A₀...A₆) de mémoires fixes (5, 6, 7) dans lesquelles sont mémorisés des tableaux de code pour respectivement une partie de mot de données (b₀, b₁, b₂ ; b₃, b₄, b₅ ; b₆, b₇, b₈) des mots de données comprimées, l'excitation d'une partie des entrées d'adresse (A₀...A₆) se faisant par des groupes qui se chevauchent (X₀...X₆, X₃...X₉, X₆...X₁₂) de bits de données non comprimés et l'excitation d'une autre partie des entrées d'adresses (A₇, A₈, A₉) par les bits (R₀, R₁, R₂) d'un facteur de cadrage commun généré dans le circuit de calcul du facteur de cadrage (4) et le nombre des bits de données qui se chevauchent correspondant à la différence entre la longueur du mot de données non comprimées et du mot de données comprimées.

2. Dispositif selon la revendication 1, **caractérisé en ce** que la compression sert à la réduction des données sur la base de codages NICAM, comme par exemple pour le D2-MAC et que trois zones de mémoires fixes ou mémoires fixes séparées (5, 6, 7) avec dix entrées d'adresse chacune (A₀...A₉) et trois sorties de données chacune (D₀...D₂) sont prévues, que l'une des parties des entrées d'adresse pour les bits de données non comprimées comprend respectivement sept de ces entrées d'adresse (A₀...A₆) et l'autre partie pour les bits du facteur de cadrage respectivement les trois entrées d'adresse qui restent (A₇...A₉).

3. Dispositif selon la revendication 2, **caractérisé en ce** que les sept entrées d'adresse (A₀...A₆) pour les valeurs significatives 2⁰...2⁶ de la première zone de mémoire fixe ou de la mémoire fixe (5) sont excitées avec des bits de la valeur significative 2⁰...2⁶ des mots de données non comprimées, les mêmes entrées d'adresses (A₀...A₆) de la seconde zone de mémoire fixe ou de la mémoire fixe (6) avec des bits de la valeur significative 2³...2⁹ des mots de données non comprimées et les mêmes entrées d'adresses (A₀...A₆) de la troisième zone de mémoire fixe ou de la mémoire fixe (7) avec des bits de la valeur significative 2⁶...2¹² des mots de données non comprimées.

4. Dispositif selon l'une ou plusieurs des revendications 1 à 3, **caractérisé en ce** que le bit de poids fort des mots de données non comprimées représente en particulier la polarité des mots de données et reste inchangé lors de la compression.
